Europäisches Patentamt

European Patent Office

Office européen des brevets

(11) Veröffentlichungsnummer: 0 295 446
A2

## (12) EUROPÄISCHE PATENTANMELDUNG

(21) Anmeldenummer: 88107979.2

(22) Anmeldetag: 18.05.88

(51) Int. Cl.4: H05K 1/11

(30) Priorität: 22.05.87 DE 3717306

(43) Veröffentlichungstag der Anmeldung:
21.12.88 Patentblatt 88/51

(84) Benannte Vertragsstaaten:
DE FR GB IT

(71) Anmelder: Wilhelm Ruf KG
Schwanthaler Strasse 18
D-8000 München 2(DE)

(72) Erfinder: Pilch, Hans
Waldstrasse 48
D-8011 Neukirch/Stockach(DE)
Erfinder: Hochholzer, Reinhard
Leonhardstrasse 19
D-8011 Höhenkirchen(DE)

(74) Vertreter: von Bülow, Tam, Dipl.-Ing.,
Dipl.-Wirtsch.-Ing. et al
SAMSON & BÜLOW Widenmayerstrasse 5
D-8000 München 22(DE)

(54) Verfahren zum Herstellen eines elektrischen Kontaktes und nach dem Verfahren hergestellte Leiterbahnplatte.

(57) Es wird ein Verfahren zum Herstellen eines niederohmigen elektrischen Kontaktes zwischen elektrisch leitenden Teilen beschrieben, das sich dadurch auszeichnet, daß die Teile mit ihren Kontaktflächen aneinandergepreßt und derart gehaltert im Bereich der aneinandergepreßten Kontaktflächen kraftschlüssig in Kunststoff eingegoßen werden. Des weiteren wird eine Leiterbahnplatte beschrieben, deren Leiterbahnen und metallische Anschlußteile mit Hilfe dieses Verfahrens kontaktiert sind.

FIG.1a

FIG.1b

Xerox Copy Centre

EP 0 295 446 A2

### Verfahren zum Herstellen eines elektrischen Kontaktes und nach dem Verfahren hergestellte Leiterbahnplatte

Die Erfindung betrifft ein Verfahren zum Herstellen eines elektrischen Kontaktes zwischen elektrisch leitenden Teilen gemäß dem Oberbegriff des Patentanspruches 1 sowie eine nach dem Verfahren hergestellte Leiterbahnplatte gemäß dem Oberbegriff des Patentanspruches 5 sowie schließlich eine Verwendung der nach dem Verfahren hergestellten Leiterbahnplatte.

Ein spezielles Anwendungsgebiet der Erfindung ist das Kontaktieren von Leiterbahn- oder Widerstandsplatten mit Steckerstiften, Lötösen oder Lötfahnen. Ein guter Kontakt zwischen elektrisch leitenden Teilen zeichnet sich bekanntlich durch einen möglichst geringen ohmschen Übergangswiderstand aus. Die Höhe des ohmschen Übergangswiderstandes hängt stark vom mechanischen Druck zwischen den Kontaktteilen ab.

Bisher hat man diesen Druck durch Nieten oder Klammern erzeugt. Zu diesem Zweck wurde an den Kontaktstellen der Leiterbahnplatte Bohrungen gefertigt. In die Bohrlöcher wurden dann die entsprechenden Stifte etc. eingesetzt und mit einer Federscheibe vernietet. In manchen Fällen wurde nach dem Nieten auch noch der Bereich um den Niet herum gelötet. Auch wurde statt des Nietens nur gelötet.

Diese Herstellschritte sind arbeitsaufwendig und entsprechend teuer. Zusätzlich wird die Leiterbahnplatte beim Nieten mechanisch beansprucht, was zu Haarrissen der Leiterbahnen und/oder der Leiterbahnplatte führt. Ein weiterer Nachteil des Nietens zum Zweck des elektrischen Kontaktierens besteht darin, daß der elektrische Übergangswiderstand zwischen der Nietstelle und der Leiterbahn nicht eindeutig reproduzierbar ist, da die mechanischen Kontaktkräfte zwischen Leiterbahn und Federscheibe bzw. Niet unmittelbar vom Nietvorgang abhängen. Auch tritt beim Nieten das Problem der Spaltkorrosion auf, wenn die Leiterplatte in Umgebungen mit hoher Luftfeuchtigkeit verwendet wird. Beim Löten traten dagegen die Probleme der Alterung und der Haarrisse bei Temperaturschwankungen auf, so daß auch gelötete Kontaktierungen ausfallen können.

Aufgabe der Erfindung ist es daher, das eingangs genannte Verfahren dahingehend zu verbessern, daß es mit einfach durchzuführenden und wenigen Arbeitsschritten einwandfreie und reproduzierbare elektrische und mechanische Verbindungen gewährleistet. Weiterhin ist es Aufgabe der Erfindung, eine Leiterbahnplatte der eingangs genannten Art in der gleichen Weise wie beim Verfahren angegebene zu verbessern.

Diese Aufgabe wird bezüglich des Verfahrens durch die im Kennzeichenteil des Patentanspruchs 1 angegebenen Merkmale gelöst. Bezüglich der Leiterbahnplatte wird die Aufgabe durch die im Kennzeichenteil des Anspruchs 5 angegebenen Merkmale gelöst. Vorteilhafte Ausgestaltungen und Weiterbildungen der Erfindung sind in den Unteransprüchen angegeben. Eine bevorzugte Verwendung der Erfindung ist bei Potentiometern oder Trimmer-Widerständen gegeben.

Der Kern der Erfindung besteht also bezüglich des Kontaktierungsverfahren darin, daß die mit Druck aneinandergepreßten Kontaktflächen der zu kontaktierenden elektrisch leitenden Teile kraftschlüssig in Kunststoff eingegossen werden. Diese Kontaktierung zeichnet sich durch einen eindeutig reproduzierbaren elektrischen Übergangswiderstand aus, da die Kontaktkräfte durch die Schwindung bzw. Schrumpfung des Kunststoffes beim Aushärten bestimmt sind. Diese Schwindung oder Schrumpfung des beim Spritzgußverfahren verwendeten Kunststoffes ist eine feststehende Materialeigenschaft des verwendeten Kunststoffes. D.h. mit anderen Worten, daß sich alle Kontaktierungen, die mit demselben Kunststoffmaterial beim Spritzvorgang hergestellt sind, durch dieselben Kontaktkräfte auszeichnen.

Wichtig bei der erfindungsgemäßen Kontaktierung ist, daß der Kraftfluß um die Kontaktierungsstelle herum geschlossen ist.

Als Spritzgußkunststoffe kommen Duroplaste ebenso in Frage wie Thermoplaste.

Es wurde festgestellt, daß die durch den Kunststoff aufgrund dessen Schwindung entstehender Kontaktkraft stets deutlich größer ist als Gegenkräfte, die bei der Weiterverarbeitung der kontaktierten Teile oder beim späteren Gebrauch von mit diesen Teilen versehenen Gegenständen auftreten. Auch ist diese Kontaktkraft noch ausreichend groß, wenn sich der Kunststoff beim Anlöten der Lötfahne erwärmt und dabei eine gewisse Erweichung auftritt. Mit anderen Worten ist auch unter thermischer Belastung der mit Hilfe des erfindungsgemäßen Verfahrens kontaktierten Teile eine sichere Verbindung dieser Teile miteinander bei niedrigem ohmschen Übergangswiderstand gewährleistet.

Das erfindungsgemäße Verfahren läßt sich besonders vorteilhaft auf eine Leiterbahnplatte anwenden, die aus einem Träger aus elektrisch isolierendem Material besteht sowie aus auf dem Träger aufgebrachten Leiterbahnen sowie aus metallischen Teilen. Die erfindungsgemäße Kontaktierung findet dabei zwischen den Leiterbahnen und den elektrisch leitfähigen Teilen statt. Der dabei ausgebildete Kontakt wird mit Vorteil von mechanischen und thermischen Gegenkräften entkoppelt, indem der Träger der Leiterbahnplatte zumindest im Kontaktierungsbereich mit in den Kunststoff eingegossen ist. Eine bevorzugte Verwendung der Erfindung ist bei Potentiometern anzuführen. Dort können die übliche Widerstandsplatte und die Lötfahnen in eine Spritzgußform eingelegt werden, wobei die Lötfahnen dann mit Anpreßdruck gegen die Kontaktierungsflächen auf der Widerstandsbahn gepreßt werden. Sodann kann komplett das Gehäuse des Potentiometers gespritzt werden und dabei gleichzeitig auch die Kontaktierung erfolgen. Der für die Kontaktierung nach der Erfindung verwendet Kunststoff-Verbindungskörper ist damit integrierter Bestandteil des Gehäuses.

Eine zusätzliche Stabilisierung des Kontaktes läßt sich dadurch erreichen, daß die metallischen Teile im Kontaktbereich mit den Leiterbahnen durch einen Kontaktkleber verbunden sind.

Wegen der beiden zur Druckausübung bei der Kunststoffumspritzung verwendeten Stempel, weist das Kunststoffverbindungteil zwei einander gegenüberliegende Öffnungen auf, durch welche der Kontaktkleber vorteilhafterweise eingebracht werden kann. Eine Klebverbindung zwischen Metallteil und Leiterbahn läßt sich dadurch erreichen, daß das Metallteil im Bereich der vom Stempel erzeugten Öffnung eine Bohrung aufweist, in welche das elektrisch leitende Klebmittel von außen eingebracht wird.

Zusätzliche Federn der Kontaktelemente zwischen den Leiterbahnen und den Kontaktflächen der metallischen Teile gewährleisten auch dann noch eine einwandfreie Kontaktierung, wenn extrem starke Gegenkräfte an der Kontaktstelle angreifen. Alternativ zu derartigen federnden Kontaktelementen können auch die Metallteile selbst mit Vorteil im Kontaktbereich federnd ausgebildet sein, beispielsweise durch eine Aufbiegung oder Aufwölbung des Kontaktendes der Lötfahne.

Gemäß einer besonders vorteilhaften Ausgestaltung der erfindungsgemäßen Leiterbahnplatte sind die Kontaktenden der metallischen Teile gabelförmig ausgebildet, wobei diese Gabelenden den Träger der Platte im Kontaktierungsbereich umgreifen. Auch diese Verbindung zeichnet sich durch eine hohe mechanische und damit letztendlich elektrische Stabilität aus.

Im nachfolgenden soll die Erfindung anhand der Zeichnungen näher erläutert werden. Es zeigen:

Fig. 1a und 1b eine erste Ausführungsform der erfindungsgemäßen Leiterbahnplatte im Schnitt bzw. in Draufsicht;

Fig. 2 eine zweite Ausführungsform der erfindungsgemäßen Leiterbahnplatte in Schnittansicht;

Fig. 3 eine dritte Ausführungsform der erfindungsgemäßen Leiterbahnplatte in Schnittansicht;

Fig. 4 eine vierte Ausführungsform der erfindungsgemäßen Leiterbahnplatte in Schnittansicht;

Fig. 5 eine fünfte Ausführungsform der erfindungsgemäßen Leiterbahnplatte in Schnittansicht;

Fig. 6 eine sechste Ausführungsform der erfindungsgemäßen Leiterbahnplatte in Schnittansicht und

Fig. 7 einen Längsschnitt durch ein Drehpotentiometer, das mit der erfindungsgemäßen Leiterplatte ausgerüstet ist.

Gleiche Bezugszeichen in den einzelnen Zeichnungen bezeichnen gleiche Teile.

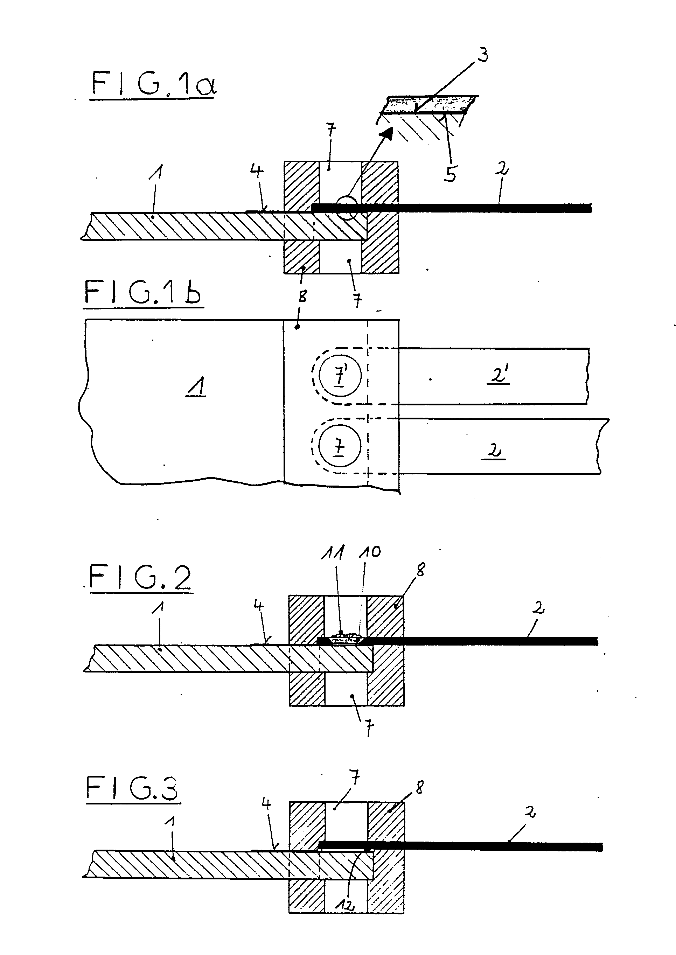

Die in Fig. 1 und 1a dargestellte Leiterbahnplatte umfaßt einen Träger 1 aus elektrisch isolierendem Material. Eine Oberfläche des Trägers 1 ist in bekannter Weise mit einer Vielzahl von Leiterbahnen 4 versehen, die sich bis in den Endbereich des Trägers 1 erstrecken und dort in Kontaktflächen münden. Dort sind die Leiterbahnen 4 mit Lötfahnen 2, 2′ kontaktiert, und zwar mit Hilfe eines Verbindungsblocks 8 aus isolierendem Material, vorzugsweise aus spritzbarem Kunststoff.

Zum Zwecke der Kontaktierung werden die Lötfahnen 2 vor dem Angießen des Verbindungsblocks 8 an den Träger I mit ihren Kontaktflächen 3 auf den Oberflächen 5 der Leiterbahnenden angeordnet. Während des Spritzgießens werden die zu kontaktierenden Leiterbahnen und Lötfahnen mit Hilfe von Stempeln aneinander gepreßt. Es greift jeweils ein Stempel an der Unterseite des Trägers 1 und ein weiterer Stempel an der Oberseite der Lötfahne 2 an, und die beiden einander gegenüberliegenden Stempel werden unter Verpressung der Kontaktflächen gegeneinander verspannt. Erst dann, wenn der die Stempel im Kontaktierungsbereich in einer Form umgebende Kunststoff ausgehärtet ist, werden die Stempel von den Kontaktstellen zurückgezogen, und der beim Aushärten geschrumpfte Kunststoff des Verbindungsblocks 8 übernimmt nunmehr die Verspannung und damit Kontaktierung der Lötfahnen mit dem am Träger 1 ausgebildeten Leiterbahnen 4.

Die dergestalt erzeugten Kontakte verlaufen im wesentlichen ringförmig um die von den Stempeln im Verbindungsblock 8 erzeugten Bohrungen 7.

Der Verbindungsblock 8 von Fig. 1 b weist im wesentlichen quaderförmige Gestalt auf und umschließt zusätzlich zu den Kontaktierungsflächen 3,5 auch relativ große Bereiche des Trägers 1. Dadurch wird eine ausgezeichnete Entlastung der Kontaktierungen 3,5 bei mechanischer Beanspruchung erreicht.

Das Ausführungsbeispiel der Leiterbahnplatte von Fig. 2 unterscheidet sich von der vorgehend dargestellten Ausführungsform, dadurch, daß in der Lötfahne 2 innerhalb des ringförmigen Kontaktierungsbereichs eine Bohrung 10 ausgebildet ist. Diese Bohrung 10 liegt im Bereich der Stempelöffnung 7, durch welche sie von außen zugänglich ist. In die Lötfahnenbohrung 10 ist ein elektrisch leitender Klebstoff 11 eingebracht, der die Wandung der sich nach außen konisch erweiternden Bohrung 10 mit der Kontaktoberfläche 5 der Leiterbahn verbindet.

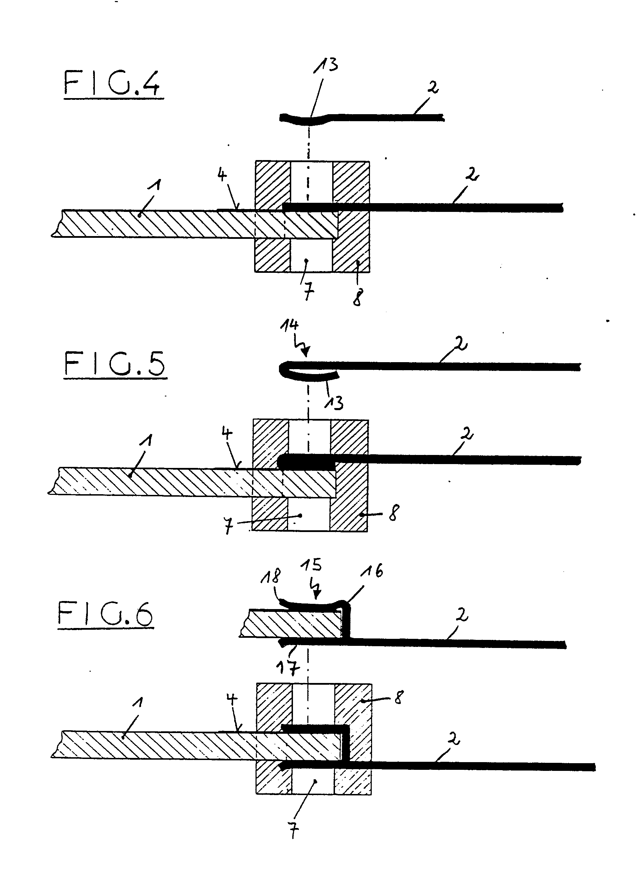

Die Leiterbahnplatte von Fig. 3 unterscheidet sich von derjenigen der Fig. 1 a und 1 b durch ein federndes, ringförmiges Kontaktelement 12, das vor dem Angießen des Verbindungsblocks 8 zwischen die jeweiligen Kontaktflächen 3 und 5 der Lötfahne 2 und der Leiterbahn 4 eingebracht wurde. Während der Druckbeaufschlagung durch die Stempel nimmt das federnde Kontaktelement 12 unter elastischer Verformung einen Teil dieser Kraft auf und gibt sie nach erfolgter Aushärtung und Schrumpfung des Kunststoffes an die miteinander zu kontaktierenden Flächen ab. Damit stellt das Kontaktelement 12 im ausgehärteten Verbindungsblock 8 einen konstant auf die Kontaktflächen einwirkenden Druckspeicher dar, der auch große von außen einwirkende Gegenkräfte auf den Kontaktierungsbereich unter Aufrechterhaltung eines niederohmigen Übergangswiderstands zwischen den Kontaktpartnern aufzufangen und auszugleichen vermag. Selbstverständlich ist die Form des Kontaktelements 12 nicht auf eine ringförmige Gestalt beschränkt.

Ein vergleichbarer Effekt wie der mit dem federnden Kontaktelement 12 erreichbare läßt sich auch mit einem federnd ausgebildeten Kontaktende der Lötfahne 2 erzielen. So zeigt Fig. 4 eine Lötfahne 2, deren Kontaktende vor dem Einspritzen auf die Kontaktfläche 5 der Leiterbahn zu gewölbt ist. Nach dem Erstarren des Kunststoff-Verbindungsblockes 8 ist die Wölbung 13 im wesentlichen ausplaniert und stellt damit einen Druckspeicher im oben beschriebenen Sinne dar.

In Fig. 5 ist die federnde Ausbildung des Kontaktendes der Lötfahne 2 durch eine Faltung des Lötfahnenendes erreicht, wobei das umgefaltete Ende 14 ähnlich wie in Fig. 4 auf die Kontaktfläche 5 der Leiterbahn zugewölbt ist. Auch hier bleibt nach dem Aushärten des Kunststoffes des Verbindungsblocks 8 eine Ausplanierung der Wölbung 13 mit dem Effekt der Verspannung des Lötfahnenendes gegenüber der Leiterbahn zusätzlich zur Schrumpfkraft des Kunststoffes.

Gemäß Fig. 6 ist das Kontaktende der Lötfahne 2 gabel-oder krallenförmig ausgebildet und umgreift damit den Träger zwischen Leiterbahn und der Unterseite dieses Körpers. An ihren Enden weist die Kralle 15 Aufbiegungen 17 und 18 auf. Zusätzlich ist die Kralle 15 im Bereich der stirnseitigen Kante des Trägers 1 nach oben gewölbt. Nach dem Erstarren des angespritzten Kunststoff-Verbindungsblockes 6 werden die Aufbiegungen 18 sowie die Wölbung 16 unter Verspannung der Kontaktpartner gegeneinander ausplaniert. Die Aufbiegung 17 hingegen ist nicht elastisch ausgeführt und behält innerhalb des ausgehärteten Verbindungsblockes 6 seine aufgebogene Form, durch welche dieser Krallenabschnitt eine zusätzliche mechanische Verankerung der Lötfahne 2 im Verbindungsblock 6 bewirkt.

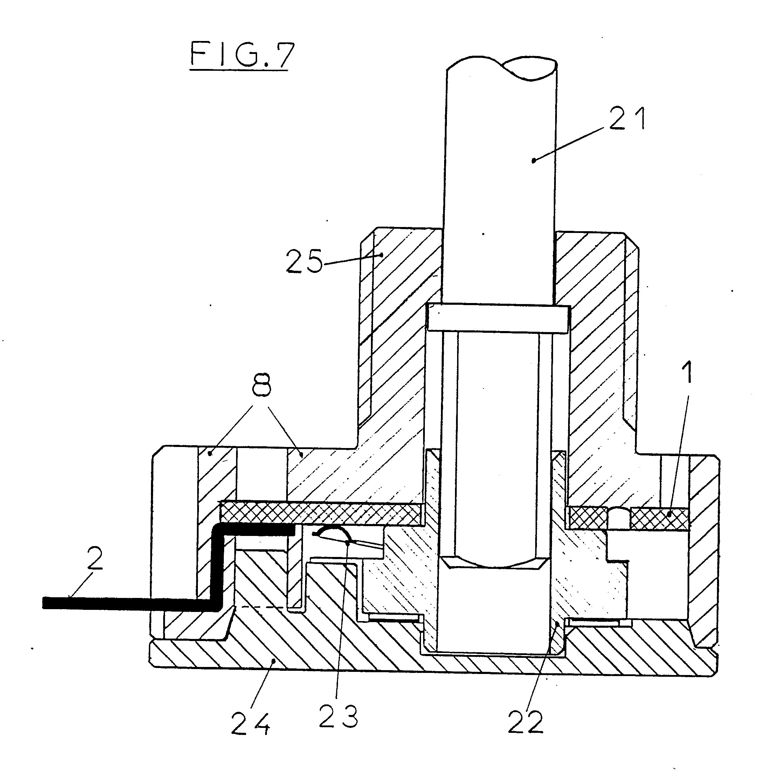

In Fig. 7 ist ein Drehpotentiometer 20 dargestellt, der in an sich bekannter Weise aufgebaut ist und die soeben beschriebene Leiterbahnplatte als Träger der Widerstandsbahn enthält. In das Gehäuse dieses Drehpotentiometers ist zwischen seinem Bodenteil 24 und dem Träger 1 der Leiterbahnplatte ein Betätigungsglied 22 drehbar eingesetzt, das in an sich bekannter Weise eine Kontaktfeder 23, den sog. Schleifer des Drehpotentiometers trägt. Verstellbar ist das Betätigungsglied 22 über eine aus dem Gehäuse des Trimmwiderstands herausragende Stelle Achse 21.

Das Gehäuse des Drehpotentiometers besteht im wesentlichen aus der bereits erwähnten Bodenplatte 24 und einem oberen Gehäuseteil 25. Diese beiden Teile werden getrennt von einander im Spritzgußverfahren hergestellt, wobei das Gehäuseoberteil 25 zusammen mit dem Verbindungsblock 6 gespritzt wird. Dieses spritzgußgefertigte Gehäuse weist mit Hinblick auf ein späteres Einlöten im Schwallbad etc. den Vorteil auf, daß es im Bereich der Lötfahne kolofoniumdicht ist.

## Ansprüche

1. Verfahren zum Herstellen eines elektrischen Kontaktes zwischen elektrisch leitfähigen Teilen, insbesondere zum Kontaktieren von Leiterbahn- bzw. Widerstandsplatten mit Anschluß- bzw. Lötfahnen, dadurch gekennzeichnet, daß die leitfähigen Teile an ihren Kontaktflächen durch eine extern aufgebracht Kraft aneinandergepreßt und derart gehaltert mit Kunststoffmaterial derart umgossen werden, daß bei ausgehärtetem Kunststoff dieser eine die Teile im Bereich der Kontaktierungsstellen gegeneinander pressende Druckkraft auf die Teile ausübt.

2. Verfahren nach Anspruch 1, dadurch gekennzeichnet, daß das Kunststoffmaterial derart aufgebracht wird, daß es einen geschlossenen Kraftfluß um die Kontaktierungsstelle herum erzeugt.

3. Verfahren nach Anspruch 1 oder 2, dadurch gekennzeichnet, daß die externe Kraft durch einander gegenüberliegende, die zu kontaktierenden Teile beaufschlagende Stempel erzeugt wird und daß die Stempel im Kontaktierungsbereich mit Kunststoff umgossen und nach dem Aushärten des Kunststoffes aus dem derart erzeugten Kunststoff-Verbindungskörper entfernt werden.

4. Verfahren nach Anspruch 3, dadurch gekennzeichnet, daß der Kunststoff-Verbindungskörper einstückiger Bestandteil eines Gehäuses ist, welches eines der Teile beherbergt und aus welchem Abschnitte der anderen Teile herausragen.

5. Leiterbahnplatte mit einem Träger aus elektrisch isolierendem Material, mit auf dem Träger aufgebrachten Leiterbahnen und/oder Widerstandsbahnen und mit elektrisch leitfähigen Teilen, insbesondere Lötfahnen, deren Enden bzw. Kontaktflächen an Kontaktierungsstellen mit den Leiterbahnen mechanisch und elektrisch verbunden sind, insbesondere nach dem Verfahren einer der Ansprüche 1 bis 4, dadurch gekennzeichnet, daß der Träger (1) und das mindestens eine elektrisch leitfähige Teil (2) im Bereich der Kontaktierungsstelle in Kunststoff (8) eingebettet sind, derart, daß der Kunststoff auf die beiden Teile (1 und 2) im Bereich der Kontaktierungsstelle (3, 5) eine, die Teile zusammenpressende, Kraft ausübt.

6. Leiterbahnplatte nach Anspruch 5, dadurch gekennzeichnet, daß das metallische Teil (2) im Kontaktierungsbereich (3, 5) zusätzlich durch einen Kontaktkleber (11) mit der Leiterbahn (4) verbunden sind.

7. Leiterbahnplatte nach Anspruch 5, dadurch gekennzeichnet, daß zwischen den Leiterbahnen (4) und den Kontaktflächen (3) der metallischen Teile (2) federnde Kontaktelemente (12) angeordnet sind.

8. Leiterbahnplatte nach Anspruch 5, dadurch gekennzeichnet, daß die metallischen Teile (2) im Kontaktierungsbereich (3, 5) federnd ausgebildet sind.

9. Leiterbahnplatte nach Anspruch 5, dadurch gekennzeichnet, daß Kontaktenden der metallischen Teile (2) gabelförmig ausgebildet sind und daß diese Enden (15) den Träger (1) im Kontaktierungsbereich (3, 5) beidseitig umgreifen.

10. Leiterbahnplatte nach einem der Ansprüche 5 bis 9, dadurch gekennzeichnet, daß der Kunststoff (8) einstückiger Bestandteil eines den Träger (1) umgebenden Gehäuses ist, aus welchem Abschnitte der elektrisch leitfähigen Teile (2), der insbesondere als Lötfahne oder Lötstift ausgebildet sind, herausragen.

11. Verwendung der Leiterbahnplatte nach einem der Ansprüche 5 bis 10 in einem Potentiometer oder Trimmer-Widerstand (20).

FIG.1a

FIG.1b

FIG.2

FIG.3

FIG.4

FIG.5

FIG.6

FIG.7